# EUROPEAN PATENT APPLICATION

(11) **EP 3 026 692 A1**
(43) Date of publication of application: **01.06.2016**
(21) Application number: 14194743.2
(22) Date of filing: 25.11.2014
(51) Int. Cl.: H01L 21/027, H01L 21/033

(54) **Method for manufacturing pillar or hole structures in a layer of a semiconductor device, and associated semiconductor structure**

(71) Applicant: IMEC VZW, 3001 Leuven (BE); Katholieke Universiteit Leuven, 3000 Leuven (BE)
(72) Inventor: Singh, Arjun, 3001 Leuven (BE); Gronheid, Roel, 3001 Leuven (BE)
(74) Representative: Office Kirkpatrick

(57) **Abstract**

Method for manufacturing pillar structures in a layer of a semiconductor device, the pillar structures being arranged at positions forming a hexagonal matrix configuration, the method comprising:
- embedding alignment pillar structures in a backfill brush polymer layer, the backfill brush polymer layer having a thickness which is about equal to the height of the alignment pillar structures, the alignment pillar structures being at positions corresponding to a subset of the positions of the hexagonal matrix configuration;
- providing a BCP layer on a substantially planar surface defined by an upper surface of the alignment pillar structures and the backfill brush polymer layer;
- inducing polymer micro phase separation of the BCP polymer layer into pillar structures of a first component of the BCP polymer layer embedded in a second component of the BCP polymer layer, the pillar structures of the first component being arranged at positions forming the hexagonal matrix configuration; and such that on each alignment pillar structure a pillar structure of a first component of the BCP polymer layer is formed; and associated semiconductor structure.

## Description

### Technical field

The present disclosure relates to methods for manufacturing nano scale pillar structures in a layer of a semiconductor device, and associated semiconductor structure.

### Background art

Block copolymer (BCP) materials are known in the art. A block copolymer is a copolymer formed when the two monomers cluster together and form 'blocks' of repeating units.

It is known that some di-block copolymers, when formulated with specific composition asymmetry, micro-phase separate into cylindrical domains at equilibrium conditions. The minority block forms cylinders while the majority block occupies space around each cylinder. At equilibrium, these cylindrical domains assemble into hcp (hexagonal close packed) lattices for bulk polymer while they assemble into hexagonal arrays for thin films (thickness smaller than 200nm). The diameter and pitch of the cylindrical domains is determined by the molecular mass of the polymer. If the polymer formulation has a dispersity ≈ 1, the pitch and diameter of such cylindrical phase BCPs is very uniform. This good uniformity and control of feature sizes makes them excellent candidates for patterning exercises.

Chemo-epitaxy, i.e. controlled and selective modification of certain substrates, can be used to guide the assembly of BCP molecules. This allows directed self-assembly (DSA) of the aforementioned cylindrical domains perpendicular to the substrate while also pre-determining their locations.

One type of chemo-epitaxial DSA has been reported in literature, as for instance in "Density Multiplication and Improved Lithography by Directed Block Copolymer Assembly", Ricardo Ruiz et al. Science 321, 936 (2008). These previous efforts have utilised electron beam lithography to form the DSA guiding pattern on lab scale substrates. E-beam lithography is used for making hexagonal contact hole arrays whose pitch is a positive integer function of the BCP's natural pitch. Using DSA to effectively enhance the pitch of the lithography patterns is called frequency or density multiplication. The frequency multiplication factor is defined as the number of resulting DSA holes in the hexagonal unit cell of the lithography pre-pattern.

After printing a pre-pattern, an oxidising plasma is used to selectively modify the substrate through these e-beam patterned holes. The substrate material is chosen such that it is highly suitable for wetting by the majority block while the plasma modified substrate is very suitable for wetting by the cylinder forming block. The e-beam resist is removed after etch to reveal the nano-patterned substrate. When a BCP thin film is spin coated and annealed on such a modified substrate the cylindrical domains assemble in a very regular hexagonal array. Etch selectivity between the two blocks is exploited to etch the cylinder forming block and form holes in the polymer thin film. At this point the polymer film resembles a traditional photolithography photoresist that has been patterned with a hexagonal array of contact holes.

In "Using chemo-epitaxial directed self-assembly for repair and frequency multiplication of EUVL contact-hole patterns" Arjun Singh et al. Proc. SPIE 9049, Alternative Lithographic Technologies VI, 90492F (March 28, 2014), a similar process flow has been reported, which uses EUV lithography instead of electron beams for printing the guiding pre-pattern holes. However, chemo-epitaxial DSA of such cylindrical phase BCPs requires that the pre-pattern spot size is 0.5 x to 1x times the pitch of the BCP cylinders. The lower limit of the hole size that can be resolved with ArFi lithography is at best 40nm, which means that this process flow cannot be used for patterning of sub-40 nm pitch hexagonal arrays unless much more expensive, slower and less reliable EUV lithography is employed. There exists a need for improved and alternative methods for forming nanoscale hole and/or pillar structures in a layer of a semiconductor device, the pillar structures being arranged at positions forming a hexagonal matrix configuration, especially for methods which are relatively simple and incur relatively low costs.

### Summary of the disclosure

It is an aim of the present disclosure to provide a method for manufacturing pillar or hole structures in a layer of a semiconductor device, the structures being arranged at positions forming a hexagonal matrix configuration. The method is relatively simple and incurs relatively low costs as compared to the prior art.

This aim is achieved according to the disclosure with the method showing the technical characteristics of the first independent claim.

It is another aim of the present disclosure to provide an associated use of the method.

It is another aim of the present disclosure to provide an associated semiconductor structure.

This aim is achieved according to the disclosure with a semiconductor structure comprising the steps of the second independent claim.

In a first aspect of the present disclosure, a method is disclosed comprising:
- embedding alignment pillar structures in a backfill brush polymer layer, the backfill brush polymer layer having a thickness which is about equal to the height of the alignment pillar structures, the alignment pillar structures being at positions corresponding to a subset of the positions of the hexagonal matrix configuration;
- providing a BCP layer on a substantially planar surface defined by an upper surface of the alignment pillar structures and the backfill brush polymer layer;
- inducing polymer microphase separation of the BCP polymer layer into hexagonally close packed (hcp) structures of a first component of the BCP polymer layer embedded in a second component of the BCP polymer layer, the hcp structures of the first component being arranged at positions forming the hexagonal matrix configuration; and such that on each alignment pillar structure a pillar structure of a first component of the BCP polymer layer is formed (preferably aligned therewith).

According to preferred embodiments of the present invention, the BCP layer is a di-block copolymer later. A block co-polymer refers to a polymer comprising two or more chemically different polymer blocks (or can be named as "components") covalently bonded to each other. A block co-polymer with two different polymer blocks is called a "di-block co-polymer". A block co-polymer with three different polymer blocks is called a "tri block co-polymer", and is not excluded from being used in embodiments of the present invention. In the latter case additional processing steps may have to be performed, which would though include the described common features/steps.

According to preferred embodiments, the alignment pillar structures are cross-linked polymer layer pillar structures and embedding the alignment pillar structures in the backfill brush polymer layer comprises:
- providing a cross-linked polymer layer on a substrate layer;
- providing a patterned photoresist layer on the cross-linked polymer layer, the patterned photoresist layer comprising a pattern of photoresist pillars, the position of the photoresist pillars corresponding to a subset of the positions of the hexagonal matrix configuration;
- (for instance applying a plasma etch for) trimming the photoresist pillars and transferring the pattern into the cross-linked polymer layer, resulting in cross-linked polymer layer pillars with reduced size (e.g. diameter), at the subset of the positions;
- removing the photoresist layer, e.g. selectively with respect to the cross-linked polymer layer pillars;
- providing a backfill brush polymer layer (preferably a fully grafted backfill brush polymer layer) in between the cross-linked polymer layer pillars, the backfill brush polymer layer having a thickness which is about equal to ( the difference in thickness preferably being smaller than 5nm, more preferably smaller than 3nm) the height of the cross-linked polymer layer pillars.

According to preferred embodiments, providing a backfill brush polymer layer in between the cross-linked polymer layer pillars, comprises
- providing a backfill brush polymer layer on and in between the cross-linked polymer layer pillars;
- grafting the backfill brush polymer layer by providing a suitable temperature step, such that at least a lower portion of the backfill brush polymer layer is chemically bonded (preferably covalently bonded) to the substrate layer;
- removing (e.g. by rinsing) an unbonded portion of the backfill brush polymer layer;
wherein the thickness of the cross-linked polymer layer and the lower portion of the backfill brush polymer layer is predetermined.

According to preferred embodiments, providing a suitable temperature step, such that at least a lower portion of the backfill brush polymer layer is chemically bonded to the substrate layer comprises providing a temperature step at a temperature in between 120°C and 350°C, or in between 120°C and 250°C, for a duration of a few (e.g. 1, 2, 3, 4, 5) seconds to a few minutes (e.g. 1, 2, 3, 4, 5, 10).

According to preferred embodiments, the thickness of the cross-linked polymer layer is smaller than 10 nm. According to preferred embodiments, the thickness of the cross-linked polymer layer is larger than 3 nm. More preferably, it has a thickness within the range of 5 to 7 nm.

For instance, a typical thickness of the bonded portion of the backfill brush polymer is within the range of 5 to 8nm.

According to preferred embodiments, the alignment pillar structures are provided in a 2D arrangement. They can be arranged along a single plane wherein not all alignment pillar structures are arranged along a single straight line. Preferably, the alignment pillar structures are located at positions corresponding to only a subset of the hexagonal matrix configuration, different from the full hexagonal matrix configuration. Preferably, at least three alignment pillar structures are provided.

According to preferred embodiments, the photoresist patterning is provided by means of a single illumination step.

According to preferred embodiments, the alignment pillar structures are provided at positions corresponding to a subset of the positions of the hexagonal matrix configuration. This subset of positions is preferably evenly distributed along the substrate's surface. The being evenly distributed does not necessarily imply a regular distribution. The more evenly distributed, the better the performance of methods according to the present disclosure.

According to preferred embodiments, the pitch between neighboring alignment pillar structures is about constant along a first direction and is an integer multiple of the natural periodicity L₀ of the BCP polymer layer. For instance it can be 2, 3, 4, 5 or any other multiple thereof.

According to preferred embodiments, the pitch between neighboring alignment pillar structures is about constant along a second direction and is an integer multiple of the natural periodicity L₀ of the BCP polymer layer, the second direction forming an angle with the first direction different from 0° or 180°, for instance an angle of 90°. For instance it can be 2, 3, 4, 5 or any other multiple thereof.

According to preferred embodiments, the pitch between neighboring alignment pillar structures is about constant (i.e. the same in both first and second direction) and is an integer multiple of the natural periodicity L₀ of the BCP polymer layer. For instance it can be 2, 3, 4, 5 or any other multiple thereof.

According to preferred embodiments, the alignment pillar structures are arranged evenly over a substrate layer. They can be arranged evenly over the whole substrate (main) surface, or, typically, over a predetermined area of the substrate surface. According to preferred embodiment, outside this predetermined area, an additional area (possibly a complementary portion) of the substrate surface may not be provided with alignment pillar structures. At least a portion of this additional area may also be (typically is) provided with BCP material during the process flow. The BCP material in this portion of the additional area will also undergo microphase separation at the same time with the BCP material in the predetermined area. An example of such a portion of the additional area may for instance, but not only, be an area foreseen for providing/comprising alignment structures/features (alignment structures/features are typically used to aid aligning patterns for different lithography steps). They are used as a kind of reference to help to place/position the subsequent patterns with respect to the previous patterns), for instance shaped as an alignment "cross". Such a portion may also comprise an adjacent area to the predetermined area, wherein other devices and/or layers are provided than in the predetermined area. As a result thereof, the BCP layer which underwent DSA resulting in for instance a first component and a second component being micro phase separated, has a different type of orientation in the predetermined area as in the portion of the additional area. Indeed, in the predetermined area, one of the components (e.g. a first component) will be aligned with the alignment pillars or will be positioned at a position of a regular hexagonal grid defined by these alignment features. In the portion of the additional area a similar, second, hexagonal grid can be formed by this first component, embedded in the second component. The second grid may be similar or identical in pitch, but its grid positions will not correspond to a regular extension of the hexagonal grid in the predetermined region. Moreover, typically, grain boundaries are formed in the material of the second component (which embeds the material of the first component) when a BCP material undergoes microphase separation. In each grain, the first component will form a regular hexagonal grid. Thus, within the portion of the additional area, different grains are present, each grain comprising a first component, embedded in a second component, forming pillar structures at positions corresponding to a respective regular hexagonal grid. The grids in the different grains may be similar or identical in pitch, but their grid positions do not correspond to positions defined by a regular extension of the hexagonal grid in the predetermined region, nor do they correspond to positions of a regular extension of the regular hexagonal grid of any other grain. The possible occurance of grain formation is known to the skilled person as for instance in Kenji Fukunaga et al "Large-Scale Alignment of ABC Block Copolymer Microdomains via Solvent Vapor Treatment", Macromolecules, 2000, 33 (3), pp 947-953; and for instance in Ramon J. Albalak et al, "Solvent swelling of roll-cast triblock copolymer films", Polymer, Volume 39, Issues 8-9, 1998, Pages 1647-1656.

According to preferred embodiments, the alignment pillar structures are arranged according to a hexagonal matrix configuration.

According to preferred embodiments, the alignment pillar structures are arranged according to a rectangular matrix configuration.

According to preferred embodiments, providing a patterned photoresist layer, for instance on the cross-linked polymer layer, the patterned photoresist layer comprising a pattern of photoresist pillars, is defined by means of 193 nm wavelength ArF immersion (ArFi) lithography. Alternatively, it can be defined by e-beam or EUV.

According to preferred embodiments, the cross-linked polymer layer comprises the same material as the first component of the BCP polymer layer. According to preferred embodiments, the cross-linked polymer layer comprises a dominating component of the same material as the first component of the BCP polymer layer, and a relative low amount of cross-linker material (preferably less than 10%).

According to preferred embodiments, the BCP polymer layer comprises PS-b-PMMA, and the method further comprises selectively removing the PMMA or PS component after the polymer separation.

According to preferred embodiments, the first component comprises PMMA.

According to preferred embodiments, the backfill brush polymer layer comprises or consist of a hydroxyl-terminated polymer or another polymer which is functionalized to covalently link to the substrate.

According to preferred embodiments, the method further comprises patterning an underlying substrate layer by using a pattern of the remaining component as a mask.

According to preferred embodiments, the method further comprises performing sequential infiltration synthesis (also known as synthesis in situ to the skilled person) to transform either the first or the second component into metallic material to enhance etch selectivity and optionally invert the tone of the pattern. See for instance for more details about such a process in Peng, Q. et al, (2010), "Nanoscopic Patterned Materials with Tunable Dimensions via Atomic Layer Deposition on Block Copolymers", Adv. Mater., 22: 5129-5133; and Jovan Kamcec et al, "Chemically Enhancing Block Copolymers for Block-Selective Synthesis of Self-Assembled Metal Oxide Nanostructures"ACS Nano, 2013, 7 (1), pp 339-346.

In a second aspect of the present disclosure, the use of the method according to any of the embodiments of the first aspect is disclosed for patterning the first contact layer in memory device manufacturing or in vertical channel transistor manufacturing.

In a second aspect of the present disclosure, the use of the method according to any of the embodiments of the first aspect is disclosed for patterning a capacitor layer in a DRAM device.

In a third aspect of the present invention, a method is disclosed wherein the alignment pillar structures are photoresist pillar structures and embedding the photoresist pillar structures in the backfill brush polymer layer comprises:
- providing a patterned photoresist layer on a substrate layer, the patterned photoresist layer comprising a pattern of photoresist pillars, the position of the photoresist pillars corresponding to a subset of the positions of the hexagonal matrix configuration;
- (for instance applying a plasma etch for) trimming the photoresist pillars, resulting in photoresist pillars with reduced size (e.g. reduced diameter and/or height), at the subset of the positions of the hexagonal matrix configuration;
- providing a backfill brush polymer layer in between the photoresist pillars, the backfill brush polymer layer having a thickness which is about equal or equal to the height of the photoresist pillars.

According to preferred embodiments, the photoresist patterning is provided by means of a single illumination step.

According to a fourth aspect of the present disclosure, a semiconductor structure is disclosed comprising a surface, the surface comprising a predetermined area and an additional area adjacent to the predetermined area, the semiconductor structure comprising :
- in the predetermined area: alignment pillar structures (2') embedded in a backfill brush polymer layer (4), the backfill brush polymer layer (4) having a thickness which is about equal to the height of the alignment pillar structures (2'), the alignment pillar structures (2') being at positions corresponding to a subset of positions of a hexagonal matrix configuration, and a micro-phase separated BCP layer on top of a surface defined by the backfill brush polymer layer (4) and the alignment pillar structures (2'), the microphase separated BCP layer comprising a first component embedded in a second component, the first component forming a regular hexagonal matrix configuration;
- in the additional area: the microphase separated BCP layer comprising the first component embedded in the second component, the first component forming a second regular hexagonal matrix configuration;
wherein the positions of the second regular hexagonal matrix configuration of the first component in the additional area do not correspond to positions of a regular extension of the regular hexagonal matrix configuration of the first component in the predetermined area.

Further preferred embodiments of the fourth aspect have been described in the respective description of the first aspect of the present disclosure.

In a fifth aspect of the present disclosure, a semiconductor structure is disclosed comprising:
- alignment pillar structures embedded in a backfill brush polymer layer, the backfill brush polymer layer having a thickness which is about equal to the height of the alignment pillar structures, the alignment pillar structures being at positions corresponding to a subset of positions of a hexagonal matrix configuration;
- pillar structures being arranged in a layer on the backfill brush polymer layer at positions forming the hexagonal matrix configuration;
wherein on each alignment pillar structure a pillar structure of a first component of the BCP polymer layer is present (e.g. aligned therewith).

According to preferred embodiments, the alignment pillar structures are cross-linked polymer layer pillar structures.

According to alternative embodiments, the alignment pillar structures are photoresist pillar structures.

Features and advantages disclosed for one of the above aspects of the present invention are hereby also implicitly disclosed the other aspects, mutatis mutandis, as the skilled person will recognize.

Certain objects and advantages of various inventive aspects have been described herein above. It is understood that this summary is merely an example and is not intended to limit the scope of the disclosure. The disclosure, both as to organization and method of operation, together with features and advantages thereof, may best be understood by reference to the following detailed description when read in conjunction with the accompanying drawings.

### Brief description of the drawings

The disclosure will be further elucidated by means of the following description and the appended figures.
Figures 1 (a) to (g) illustrate a process flow according to a preferred embodiment of the present disclosure.
Figures 2(a) to (f) illustrate a process flow according to an alternative embodiment of the present disclosure.
Figure 3 shows images representing experimental results according to preferred embodiments of the present disclosure.

### Detailed description of preferred embodiments

The present disclosure will be described with respect to particular embodiments and with reference to certain drawings but the disclosure is not limited thereto but only by the claims. The drawings described are only schematic and are nonlimiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Furthermore, the various embodiments, although referred to as "preferred" are to be construed as example manners in which the disclosure may be implemented rather than as limiting the scope of the disclosure.

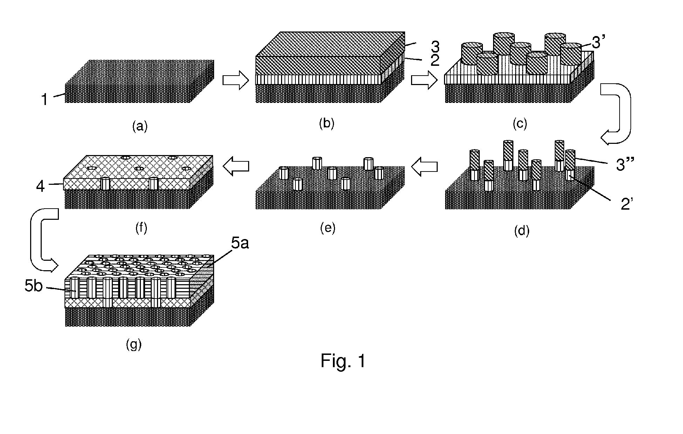

Figure 1 (a) to (g) illustrate a process flow according to a preferred embodiment of the present disclosure.

A substrate or substrate layer 1 is provided (for instance comprising a silicon substrate wafer on which a layer to be patterned is provided, such as for instance a silicon oxide, silicon nitride, titanium nitride, etc layer), which can for instance be a layer stack on an underlying semiconductor wafer (Fig. 1(a)). A cross-linked polymer layer 2 (also called mat layer) is coated on top of the substrate 1. On top of the cross-linked polymer layer 2 a photoresist layer (PR) 3 is coated (Fig. 1(b)). The photoresist layer is patterned with state of the art techniques, selectively with respect to the cross-linked polymer layer 2, to thereby define PR pillars 3' (Fig. 1(c)). The PR pillars 3' can have for instance a pitch in between 80 and 150nm, and a diameter within the range of 35-70nm. Preferably, the patterning of the photoresist layer is performed by means of ArF immersion (ArFi) lithography at 193 nm. A plasma etch step is applied to trim the photoresist pillars 3' and to transfer their pattern into said cross-linked polymer layer 2 (Fig. 1 (d)), resulting in cross-linked polymer layer pillars 2', referred to as alignment pillars 2', with reduced size, e.g. reduced diameter (for instance a pitch in between 80 and 150nm, and a diameter within the range of 10-50nm). The alignment pillars are preferably evenly distributed over at least a portion of, or over the whole substrate main surface. For instance, there may be a constant pitch between pillars. Alternatively, a first pitch may be constant in a first direction (e.g. horizontal direction) and a second pitch may be constant along a different, non-parallel, direction (e.g. vertical direction), the first and second pitches being different. They are preferably located at a subset of positions corresponding to the eventual hexagonal matrix configuration required. The main surface of the substrate 1 is modified for brush grafting. For instance, the substrate can be oxidised by the trim etch step, which can facilitate the brush grafting step. The remaining portion of the PR layer 3" is now removed (Fig. 1 (e)).

The alignment pillar structures 2' are now being laterally embedded in a backfill brush polymer layer 4 (Fig. 1(f)), for instance comprising a hydroxyl terminated random copolymer comprised of the same monomers as used for the BCP material. A predetermined backfill brush polymer layer is provided on and in between the cross-linked polymer layer pillars 2', embedding the cross-linked polymer layer pillars 2' completely. The backfill brush polymer layer is then grafted by providing a suitable temperature step, such that at least a lower portion of the backfill brush polymer layer is chemically bonded (preferably covalently bonded) to the substrate layer.A rinsing process is then applied which removes the unbonded portion of the backfill brush polymer layer, leaving only the bonded portion (grafted portion). Hereby, the thickness of the cross-linked polymer layer 2' and the grafted portion of the backfill brush polymer layer 4 is predetermined, such that they are the same or about the same height.

A BCP layer 5 is now coated on the substantially planar surface defined by the upper surface of the alignment pillar structures 2' and the backfill brush polymer layer 4 (Fig. 1 (f)). Polymer microphase separation of said BCP polymer layer 5 is induced, such that pillar structures of a first component (5b) of the BCP polymer layer are created, and a complementary structure of a second component (5a) of the BCP polymer layer which is embedding the pillar structures of a first component (5b) laterally. The pillar structures of the first component (5b) are arranged at positions forming the required hexagonal matrix configuration. Hereby, on each alignment pillar structure (2') a pillar structure of a first component (5b) of the BCP polymer layer is formed. A frequency multiplication factor of the pre-pattern defined by the alignment pillar structures of 2, 3 or more can be achieved. For instance, the set of alignment pillars forming the pre-pattern may form a rectangular grid, or any other sub-grid of a hexagonal grid, or a hexagonal grid. For instance, the set of alignment pillars may form a hexagonal grid with a pitch which is larger than the natural period of the BCP.

For instance, in the above process flow, the trim etch transfers the pillar pattern from photoresist 3" to a cross-linked PMMA (X-PMMA) under-layer (cross-linked polymer layer 2, pillars 2"). The backfill brush layer 4 can be for instance an end-grafting random copolymer of PS-PMMA with a high PS fraction (e.g. within the range of 75 to 95% PS content).

When replacing instead X-PMMA with cross-linked PS (X-PS) and adjust the backfill brush composition such that the PMMA fraction is higher (for instance within the range of 50 to 75% PS content), this flow can also be used to assemble PS cylinder forming PS-b-PMMA formulations. A step after DSA is preferably the removal of one of the blocks in the BCP. For PS-b-PMMA this block is PMMA as PMMA etches faster than PS in most plasma chemistries and can also be removed with exposure to DUV light which causes chain scission in PMMA and the residue can be rinsed away with organic solvents while PS remains in the film. This means that, if PMMA cylinder forming BCP systems are used, one ends up with holes in a PS film after PMMA removal. On the other hand if one uses PS cylinder forming BCPs, one ends up with pillars of PS after PMMA removal.

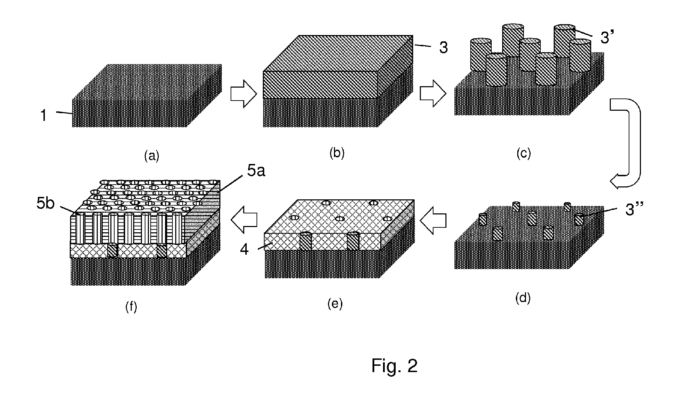

Figure 2(a) to (f) illustrate a process flow according to an alternative embodiment of the present disclosure, wherein the photoresist layer 3 itself is used for defining alignment pillar structures 3". This process flow is further similar to the flow described in relation with Fig. 1(a) to (g).

A substrate or substrate layer 1 is provided (for instance comprising a silicon substrate wafer on which a layer to be patterned is provided, such as for instance a silicon oxide, silicon nitride, titanium nitride, etc layer), which can for instance be a layer stack on an underlying semiconductor wafer (Fig. 2(a)). A photoresist layer (PR) 3 is coated/deposited on top of the substrate 1 (Fig. 2(b)). The photoresist layer 3 is patterned with state of the art techniques, selectively with respect to the substrate, to thereby define PR pillars 3' (Fig. 2(c)). Preferably, the patterning of the photoresist layer is performed by means of ArF immersion (ArFi) lithography at 193 nm. The PR pillars 3' can have for instance a pitch in between 80 and 150nm, and a diameter within the range of 35-70nm. A plasma etch step is applied to trim the photoresist pillars 3', resulting in photoresist pillars 3", referred to as alignment pillars, with reduced size, e.g. reduced diameter and/or height (Fig. 2(d)) (for instance a pitch in between 80 and 150nm, and a diameter within the range of 10-50nm). The alignment pillars 3" are preferably evenly distributed over at least a portion of, or over the whole substrate main surface. They are preferably located at a subset of positions corresponding to the eventual hexagonal matrix configuration required. For instance, there may be a constant pitch between pillars. Alternatively, a first pitch may be constant in a first direction (e.g. horizontal direction) and a second pitch may be constant along a different, non-parallel, direction (e.g. vertical direction), the first and second pitches being different.The main surface of the substrate 1 is modified for brush grafting.

The alignment pillar structures 3" are now being laterally embedded in a backfill brush polymer layer 4 (Fig. 2(e)). A predetermined backfill brush polymer layer is provided on and in between the photoresist pillars 3", embedding them completely. The backfill brush polymer layer is then grafted by providing a suitable temperature step, such that at least a lower portion of the backfill brush polymer layer is chemically bonded to the substrate layer. A rinsing process is then applied which removes the unbonded (non-bonded) portion of the backfill brush polymer layer, leaving only the bonded portion (grafted portion). Hereby, the thickness of the photoresist pillars 3" and the grafted portion of the backfill brush polymer layer 4 is predetermined, such that they are the same or about the same height.

A BCP layer 5 is now coated on the substantially planar surface defined by the upper surface of the alignment pillar structures 2' and the backfill brush polymer layer 4 (Fig. 2(e)). Polymer micro phase separation of said BCP polymer layer 5 is induced, such that pillar structures of a first component (5b) of the BCP polymer layer are created, and a complementary structure of a second component (5a) of the BCP polymer layer which is embedding the pillar structures of a first component (5b) laterally. The pillar structures of the first component (5b) are arranged at positions forming the required hexagonal matrix configuration. Hereby, on each alignment pillar structure (3") a pillar structure of a first component (5b) of the BCP polymer layer is formed. A frequency multiplication factor of the pre-pattern defined by the alignment pillar structures of 2, 3 or more can be achieved. For instance, the set of alignment pillars forming the pre-pattern may form a rectangular grid, or any other sub-grid of a hexagonal grid, or a hexagonal grid. For instance, the set of alignment pillars may form a hexagonal grid with a pitch which is larger than the natural period of the BCP.

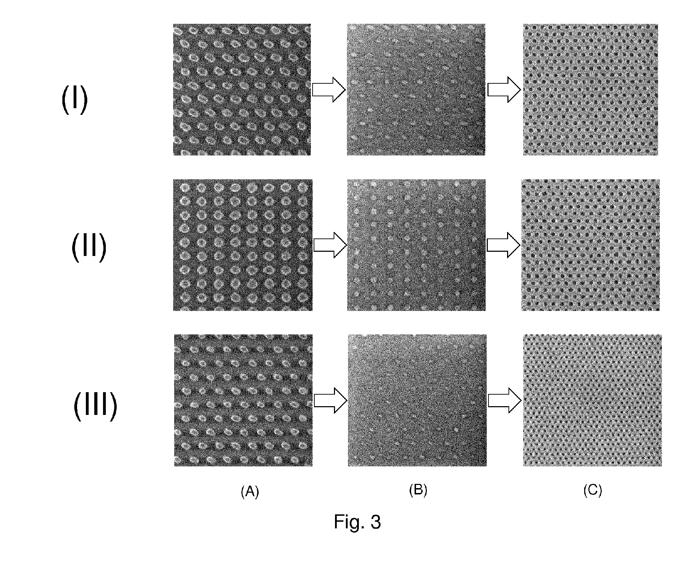

Figure 3 shows images representing experimental results according to preferred embodiments of the present disclosure, in which a cross-linked polymer layer is present, according to the flow described in relation with Fig. 1. A cross-linked (x-linked) layer 2 was spin-coated on a substrate 1 and baked at 250°C for about 2 minutes in a N2 atmosphere. A PR layer 3 was spin-coated on x-linked layer and baked at 100°C for about 1 minute. ArFi lithography was used to define the PR alignment pillars 3', using double exposure. An oxygen containing plasma etch chemistry was used in order to trim the PR pillars 3" and pattern the x-linked layer 2'. A rinse step was applied with a DMSO+TMAH photoresist stripper. Then, a brush polymer layer was spin-coated, baked at 220°C for 3 minutes, in an N2 atmospere, followed by a rinse step with PGMEA. Then, a BCP layer/film was spin-coated on the surface defined by the remaining brush polymer layer and x-linked alignment structures 2'. The BCP film was baked at 250°C for 5 minutes, in a N2 atmosphere.

Preferably, the surface energies of the remaining brush polymer layer and x-linked alignment structures are very similar. In preferred embodiments, a top coat layer can be provided on the surface defined by the remaining brush polymer layer and x-linked alignment structures, which is adapted for modifying the surface energies of one or both of the remaining brush polymer layer and x-linked alignment structures, to further optimise the process, e.g. to make their surface energies more similar. The use of these top coats (top coated layers) is known to the skilled person, as for instance in E. Huang and T. P. Russell, "Using Surface Active Random Copolymers To Control the Domain Orientation in Diblock Copolymer Thin Films", Macromolecules, 1998, 31 (22), pp 7641-7650; and for instance in Christopher M. Bates et al, "Polarity-Switching Top Coats Enable Orientation of Sub-10-nm Block Copolymer Domains", Science 9 November 2012: Vol. 338 no. 6108 pp. 775-779.

It can be noted that the processing can be identical for embodiments according to a flow described in relation with Fig. 2, wherein the double exposure in Fig. 2 (c) is for patterning a (for instance rectangular) array of alignment pillars.

The images are CD SEM images at 180kx magnification. Images are provided for three process flows: series I, II, and III. Three different stages in each of these process flows have been depicted. The left images (A) show the photoresist pillar structures after lithography. The central images (B) define the alignment pillar pre-pattern after trimming (after trim etch). The right images (C) show the BCP layer/film BCP film after DSA with PMMA domains removed using Deep UV (DUV) exposure and IPA rinse. The BCP material used here was PS-b-PMMA.

In flow (I) a 90nm pitch hexagonal array is provided at lithography level. A 45nm pitch BCP was used with the cylindrical domain etched after DSA, resulting in a frequency multiplication factor of four.

In flow (II) a 90 (first direction, e.g. horizontal direction) /78 (second direction, e.g. vertical direction) nm pitch orthogonal array (rectangular array) at lithography level is performed. A 45nm pitch BCP was used with the cylindrical domain etched after DSA, resulting in a frequency multiplication factor of four.

In flow (III) a 90nm pitch hexagonal array is provided at lithography level. A 30nm pitch BCP was applied with the cylindrical domain etched after DSA, resulting in a frequency multiplication factor of nine.

It will be appreciated by the skilled person that embodiment according to aspects of the present disclosure can be used for patterning arrays spanning 45nm to sub-30nm pitch with ArFi lithography, which meet ITRS roadmap requirements for contact holes until at least 2025. It enables a relatively simple and cheap patterning process for this critical contact layer. It can further be noted that, when assisted by EUVL instead of ArFi, the process can be extended to sub-20nm pitch thus exceeding the roadmap's predictions for the foreseeable future.

Further, this process flow can also be used to assemble cylinder forming BCPs different from PS-b-PMMA. The cross-linked mat material and backfill brush composition are preferably predetermined/selected accordingly.

Another advantage of embodiment according to aspects of the disclosure is that array or cell edges can be defined in the pre-pattern step. Unlike most chemo-epitaxy process flows a separate cut/block mask is not necessary. In the mask design, the area outside the cell edge can be a "dark field" or not exposed to the photolithography scanner's illumination. After photo-resist development, a photo-resist layer can still be present in the area outside the desired cell (e.g. using positive tone development for patterning the pillars). This photo-resist layer can then shield the under-lying cross-linked film from the trim etch. Subsequently, no brush grafts in this region outside the desired cell as the cross-linked under-layer is present to shield the substrate. The BCP molecules that assemble on this area outside the cell will be oriented parallel to the substrate and will not be transferred to the target layer in the pattern transfer process.

The foregoing description details certain embodiments of the disclosure. It will be appreciated, however, that no matter how detailed the foregoing appears in text, the disclosure may be practiced in many ways.

While the above detailed description has shown, described, and pointed out novel features of the invention as applied to various embodiments, it will be understood that various omissions, substitutions, and changes in the form and details of the device or process illustrated may be made by those skilled in the technology without departing from the invention.

## Claims

1. Method for manufacturing pillar structures in a layer of a semiconductor device, said pillar structures being arranged at positions forming a hexagonal matrix configuration, the method comprising:
- embedding alignment pillar structures (2') in a backfill brush polymer layer (4), said backfill brush polymer layer (4) having a thickness which is about equal to the height of said alignment pillar structures (2'), said alignment pillar structures (2') being at positions corresponding to a subset of the positions of said hexagonal matrix configuration;
- providing a BCP layer (5) on a substantially planar surface defined by an upper surface of said alignment pillar structures (2') and said backfill brush polymer layer (4);
- inducing polymer microphase separation of said BCP polymer layer (5) into pillar structures of a first component (5b) of said BCP polymer layer embedded in a second component (5a) of said BCP polymer layer, said pillar structures of said first component (5b) being arranged at positions forming said hexagonal matrix configuration; and such that on each said alignment pillar structure (2') a pillar structure of a first component (5a) of said BCP polymer layer is formed.

2. Method according to claim 1, wherein said alignment pillar structures are cross-linked polymer layer pillar structures and wherein embedding said alignment pillar structures (2') in said backfill brush polymer layer comprises:
- providing a cross-linked polymer layer (2) on a substrate layer (1);
- providing a patterned photoresist layer (3) on said cross-linked polymer layer (2), said patterned photoresist layer comprising a pattern of photoresist pillars (3'), the position of said photoresist pillars (3') corresponding to a subset of the positions of said hexagonal matrix configuration;
- (applying a plasma etch for) trimming said photoresist pillars (3") and transferring said pattern into said cross-linked polymer layer (2), resulting in cross-linked polymer layer pillars (2') with reduced diameter, at said subset of said positions;
- removing said photoresist layer (3);
- providing a backfill brush polymer layer (4) in between said cross-linked polymer layer pillars (2'), said backfill brush polymer layer (4) having a thickness which is about equal to the height of said cross-linked polymer layer pillars (2').

3. Method according to claim 2, wherein providing a backfill brush polymer layer (4) in between said cross-linked polymer layer pillars (2'), said backfill brush polymer layer (4) having a thickness which is about equal to the height of said cross-linked polymer layer pillars (2'), comprises
- providing a backfill brush polymer layer (4) on and in between said cross-linked polymer layer pillars;
- grafting said backfill brush polymer layer by providing a suitable temperature step, such that at least a lower portion of said backfill brush polymer layer is chemically bonded to said substrate layer (1);
- removing an unbonded portion of said backfill brush polymer layer (4);
wherein the thickness of said cross-linked polymer layer (2) and the lower portion of the backfill brush polymer layer is predetermined.

4. Method according to any of the previous claims 2 to 3, wherein said thickness of said cross-linked polymer layer (2) is smaller than 10 nm.

5. Method according to any of the previous claims, wherein said alignment pillar structures are provided in a 2D arrangement.

6. Method according to any of the previous claims, wherein the pitch between neighboring alignment pillar structures (2') is about constant and is an integer multiple of the natural periodicity L₀ of the BCP polymer layer (5).

7. Method according to claim 6, wherein said alignment pillar structures (2') are arranged according to a hexagonal matrix configuration.

8. Method according to claim 6, wherein said alignment pillar structures (2') are arranged according to a rectangular matrix configuration.

9. Method according to any of the previous claims 2 to 8, wherein providing a patterned photoresist layer (3) on said cross-linked polymer layer (2), said patterned photoresist layer (3) comprising a pattern of photoresist pillars (3'), is performed by means of ArF immersion (ArFi) lithography at 193 nm.

10. Method according to any of the claims 2 to 9, wherein said cross-linked polymer layer (2) comprises the same material as the first component of said BCP polymer layer (5).

11. Method according to any of the previous claims, wherein said BCP polymer layer (5) comprises PS-b-PMMA, and wherein the method further comprises selectively removing the PMMA or PS component after said polymer separation.

12. Method according to claim 10 or 11, further comprising patterning an underlying substrate layer (1) by using a pattern of the remaining component as a mask.

13. Method according to claim 10 or 11, further comprising performing sequential infiltration synthesis to transform either the first or the second component into metallic material to enhance etch selectivity and optionally invert the tone of the pattern.

14. Use of the method according to any of the previous claims for patterning the first contact layer in memory device manufacturing or in vertical channel transistor manufacturing.

15. A semiconductor structure comprising a surface, said surface comprising a predetermined area and an additional area adjacent to said predetermined area, the semiconduct structure comprising:
- in said predetermined area: alignment pillar structures (2') embedded in a backfill brush polymer layer (4), said backfill brush polymer layer (4) having a thickness which is about equal to the height of said alignment pillar structures (2'), said alignment pillar structures (2') being at positions corresponding to a subset of positions of a hexagonal matrix configuration, and a micro-phase separated BCP layer on top of a surface defined by said backfill brush polymer layer (4) and said alignment pillar structures (2'), said microphase separated BCP layer comprising a first component embedded in a second component, said first component forming a regular hexagonal matrix configuration;
- in said additional area: said microphase separated BCP layer comprising said first component embedded in said second component, said first component forming a second regular hexagonal matrix configuration;
- wherein the positions of the second regular hexagonal matrix configuration of said first component in said additional area do not correspond to positions of a regular extension of the regular hexagonal matrix configuration of said first component in said predetermined area.
